Europäisches Patentamt

(19) European Patent Office

Office européen des brevets

(11) Publication number: **0 200 516 B1**

(12) **EUROPEAN PATENT SPECIFICATION**

(45) Date of publication of patent specification :
05.06.91 Bulletin 91/23

(51) Int. Cl.⁵ : **H01R 9/24, H01R 13/28**

(21) Application number : **86303198.5**

(22) Date of filing : **28.04.86**

(54) **Electrical terminator device.**

(30) Priority : **29.04.85 US 727918**

(43) Date of publication of application :
**05.11.86 Bulletin 86/45**

(45) Publication of the grant of the patent :
**05.06.91 Bulletin 91/23**

(84) Designated Contracting States :
**AT BE CH DE FR GB IT LI LU NL SE**

(56) References cited :
**EP-A- 0 130 844
FR-A- 1 367 183
FR-A- 1 491 008
GB-A- 1 397 249**

(73) Proprietor : **E.I. DU PONT DE NEMOURS AND
COMPANY
1007 Market Street
Wilmington Delaware 19898 (US)**

(72) Inventor : **Papa, Ralph A.
2121 Sauers Road
Harrisburg Pennsylvania 17110 (US)**
Inventor : **Koser, James R.
330 Collefe Avenue
Elizabethtown Pennsylvania 17022 (US)**

(74) Representative : **Boyes, Kenneth Aubrey et al
Frank B. Dehn & Co. Imperial House 15-19
Kingsway
London WC2B 6UZ (GB)**

## Description

This invention relates to electrical connectors, and particularly to an electrical terminator device for terminating an open signal path of an electronic device. More particularly, this invention relates to a terminator for input/output interfaces of electronic digital computers.

Electronic digital computers are typically equipped with a plurality of input/output interface ports. In most cases, each port is a standard array of terminals to which any one of a number of peripheral devices – e.g., printers, card readers, disk drives, optical character readers, video display terminals, and modems or other devices for communicating with other computers – can be connected. Many of these peripheral devices are optional, and their absence will not affect the operation of the computer. In fact, large computers are generally provided with large numbers of input/output ports and many remain unused.

Of these ports, some may be dedicated to particular essential peripheral devices. If one of these devices is absent, it may be desirable for the computer to shut down automatically, or to automatically start or stop selected functions. Even if a port is not dedicated, it may be desirable to have some means for informing the central processing unit that it need not search for any input/output devices at that port. At the very least, it is desirable to cover unused ports to keep out dust, and to prevent accidental short circuits or physical terminal damage.

Simple covers which prevent short circuits and physical damage are well known. It is also known to provide terminator devices which indicate to the central processing unit that a port is unused or that it should shut down some or all functions or start some functions. Known terminator devices include a circuit board having impedance elements. The impedance elements are arranged to provide the appropriate information to the central processing unit, whether by matching the characteristic impedance of the input/output port or by presenting some other preselected impedance or impedances to the port or to selected terminals in the port.

The impedance elements on the circuit board must be connected to terminals which can be mated with those of the input/output port. In known terminator devices, the connections are made by providing a plurality of socket terminals on the edge of the circuit board. The terminals are designed to receive straight pins parallel to the surface of the board on which the impedance elements are located. Because many computer input/output ports are not composed of straight pins in the same configuration, it is necessary to interpose an adapter of which one end plugs into the terminals on the edge of the circuit board and which presents on its other end a set of terminals which is "plug-compatible" with the computer in question. The adapter can be separate from the terminator, or it could be built into the same housing as the circuit board. Because a circuit board having such terminals plugs into the port edge-on, it protrudes a relatively large distance from the panel in which the port is located. This is so even if no adapter is necessary. In this position, it could present a hazard to those passing by, and it is susceptible to being damaged or knocked off if struck, because of the relatively larger torque that can be applied. It would be desirable to have terminators protrude as little as possible from the computer panel.

In addition, because of the positioning of the circuit board, the lines on the circuit board are relatively long. It would be desirable to shorten them to reduce signal delay time and power dissipation.

It is therefore an object of this invention to provide an electrical terminator device that does not project significantly from the input/output interface panel to which it is connected.

It is another object of this invention to provide such a terminator device which is compact in size.

It is a further object of this invention to provide such a terminator in which the signal paths are as short as possible.

In accordance with this invention, an electrical termination device is provided for terminating a signal path having a characteristic impedance and having an array of signal terminals, said electrical termination device comprising :

a circuit board having first and second sides and a plurality of through holes, and having signal leads on at least one side in electrical contact with said plurality of through holes ;

a plurality of electrical terminals, each of said electrical terminals having first and second contact ends, each of said electrical terminals being mounted on said first side of said circuit board in a respective one of said plurality of through holes in electrical contact therewith at said first contact end, said electrical terminals extending substantially perpendicularly from said circuit board substantially parallel to one another in an array complementary to said array of signal terminals ;

a plurality of impedance elements mounted on said second side of said circuit board, each of said impedance elements being mounted in electrical contact with at least two of said plurality of through holes ;

a first dielectric housing having multiple terminal receiving channels mating with said second contact ends of said electrical terminals on said first side of said circuit board ;

a second dielectric housing for covering said impedance elements on said second side of said circuit board ; and

means for retaining said first dielectric housing, said circuit board, and said second dielectric housing in assembled sandwiched relationship ; wherein said impedance elements are selected, and said signal leads are arranged, such that said second ends of said electrical terminals present a desired impedance for terminating said signal path.

The above and other objects and advantages of the invention will be apparent after consideration of the following detailed description, taken in conjunction with the accompanying drawings, in which like reference characters represent like parts throughout and in which :

FIG. 1 is a perspective view of the device of the invention as seen from the mating end ;

FIG. 2 is a perspective view of the device of the invention as seen from the covered end ;

FIG. 3 is an exploded perspective view of the device of the invention as seen from the covered end ;

FIG. 4 is an elevational view of the device of the invention taken from line 4-4 of FIG. 1 ;

FIG. 5 is a cross-sectional view of the device of the invention taken from line 5-5 of FIG. 1 ; and

FIG. 6 is a cross-sectional view of the device of the invention taken from line 6-6 of FIG. 1.

The present invention can be used to provide line terminator devices for any type of electronic or data processing equipment. Terminator devices according to the invention can be made with any type of terminal configuration. For example, a terminator can be provided which mates with a D-subminiature connector of the type commonly used in military electronics.

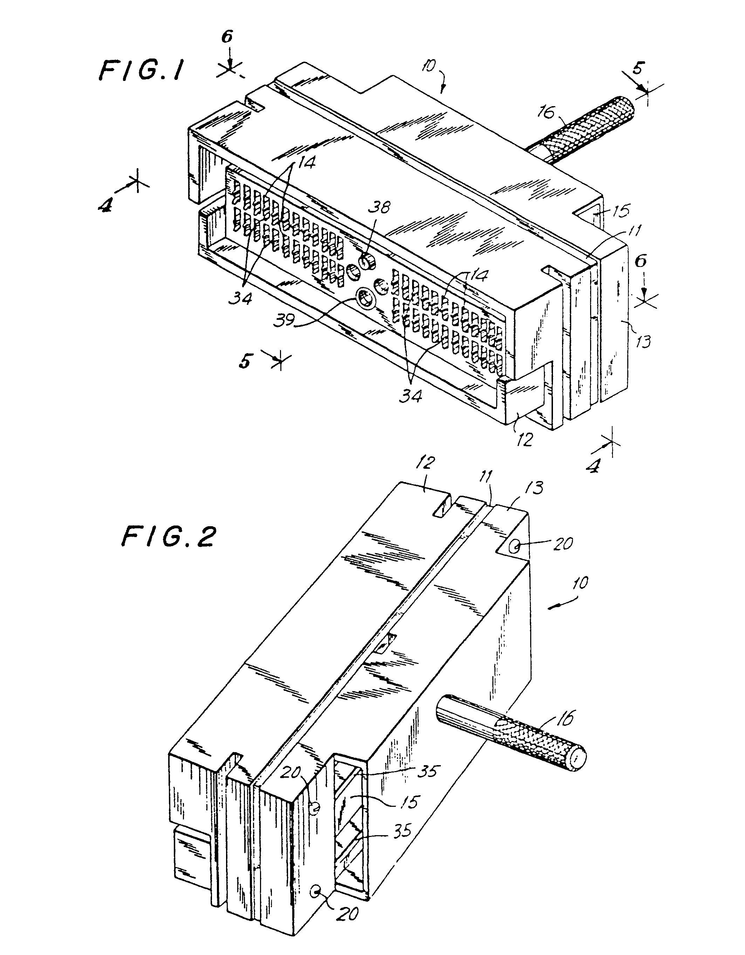

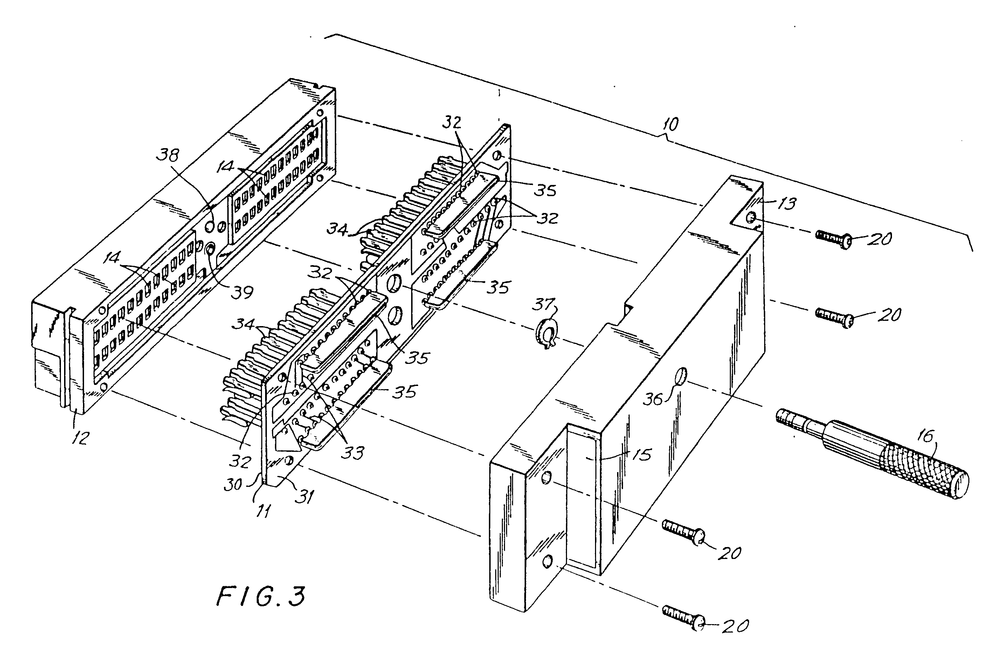

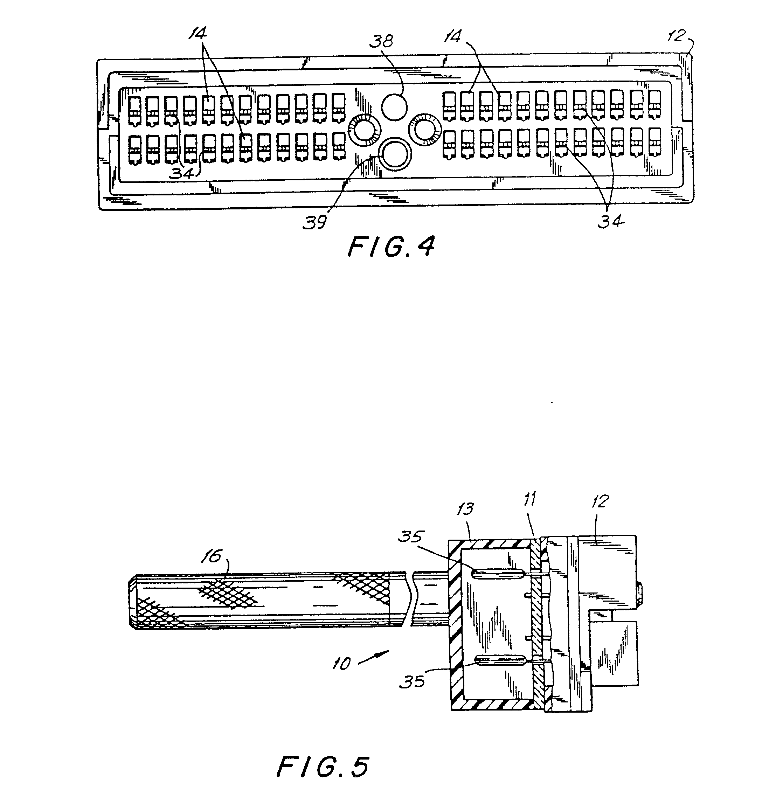

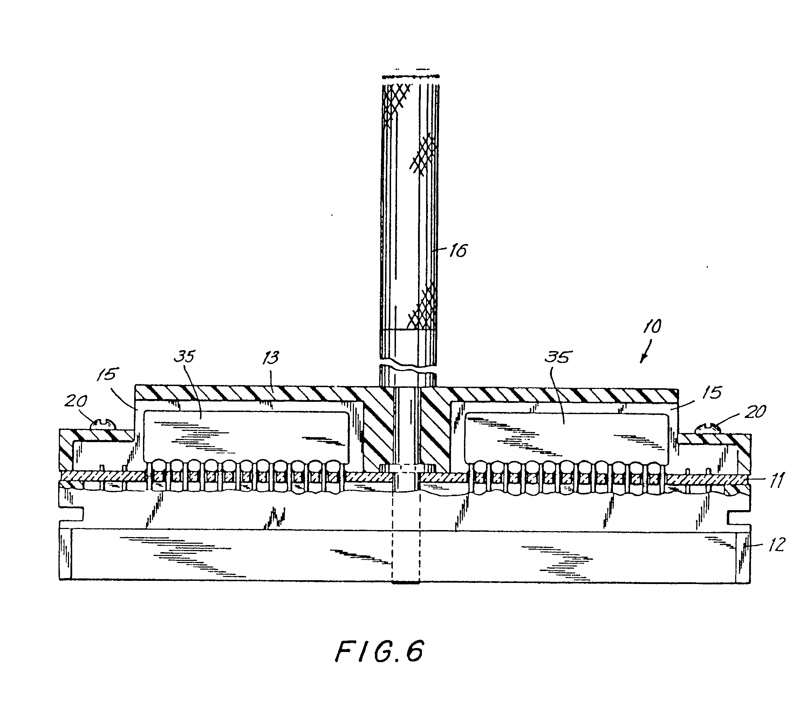

A preferred embodiment of the invention which is compatible with the 360/370 series of electronic digital computers produced by the International Business Machines Corporation (IBM), and with other IBM products, is shown in FIGS. 1-6. This embodiment is provided with an array of serpent terminals on 0.317 cm (0.125 inch) by 0.635 cm (0.250 inch) centers.

Terminator 10 includes circuit board 11 sandwiched between first dielectric housing 12 and second dielectric housing 13. Circuit board 11 is preferably made from copper clad glass fiber base epoxy resin. Dielectric housing 12 is preferably made from unfilled polycarbonate with a flammability rating of 94V-O. Dielectric housing 13 is preferably made from a thermoplastic material with a flammability rating of 94V-O.

Circuit board 11 has a first side 30 and a second side 31, and a plurality of through holes 32. Signal leads 33 are in electrical contact with through holes 32. A plurality of serpent terminals 34 are mounted on first aide 30 of circuit board 11. A first contact end of each terminal 34 is mounted in, and is in electrical contact with, a respective hole 32. Terminals 34 extend substantially perpendicularly from circuit board 11 substantially parallel to one another.

Four resistors networks 35, each equivalent to six resistors, are each mounted on circuit board 11 in electrical contact with twelve of the holes 32. Resistor networks 35, together with signal leads 33, present selected resistances between the various terminals 34. These resistances can be selected, by choosing resistor networks 35 and the arrangement of signal leads 33, to create a terminator 10 which will "tell" a computer, with an input/output port of which it is mated, that these is no device in the port, that it should shut down if the particular port in question is accessed, or that it should turn on, or any other "message" of which one skilled in the art might conceive. Other types of resistor networks or individual resistors or other types of impedance elements could also be used.

First dielectric housing 12 has a plurality of terminal receiving channels 14, one for each terminal 34. Second dielectric housing 13 covers resistor networks 35 and signal leads 33, and has ventilation openings 15 for dissipation of the heat produced by resistor networks 35. Housings 12, 13 and circuit board 11 are held together by four self-tapping screws 20.

Preferably, a jack screw 16 is provided to fix terminator 10 to the connector to which it is mated. Jack screw 16, knurled to provide a frictional surface for twisting, is attached to second housing 13 through hole 16 by a C-clip 37, which allows jack screw 16 to rotate while preventing its longitudinal withdrawal from housing 13. Jack screw 16 passes through holes 38 in circuit board 11 and first housing 12 for engagement with a threaded hole in the mating connector. A threaded insert is provided in hole 39 in first housing 12 to receive a screw, if any, from the mating connector.

By using resistor networks 35 in conjunction with signal leads 33 on a circuit board 11 mounted parallel to the mating face of terminator 10 as described above, it is thereby possible to create a terminator which is much more compact than those previously known, and which will project less from the device to which it is mated.

It will be apparent to one skilled in the art that the inventive principles disclosed herein can be practiced by other than the embodiment described, which is presented for the purposes of illustration rather than limitation, and the present invention is limited only by the claims which follow.

## Claims

1. An electrical termination device (10) for terminating a signal path having a characteristic impedance and having an array of signal terminals, said electrical termination device (10) comprising :

a circuit board (11) having first and second sides (30, 31) and a plurality of through holes (32), and having signal leads (33) on at least one side (31) in electrical contact with said plurality of through holes (32);

a plurality of electrical terminals (34), each of said electrical terminals (34) having first and second contact ends, each of said electrical terminals (34) being mounted on said first side (30) of said circuit board (11) in a respective one of said plurality of through holes (32) in electrical contact therewith at said first contact end, said electrical terminals (34) extending substantially perpendicularly from said circuit board (11) substantially parallel to one another in an array complementary to said array of signal terminals ;

a plurality of impedance elements (35) mounted on said second side (31) of said circuit board (11), each of said impedance elements (35) being mounted in electrical contact with at least two of said plurality of through holes (32) ;

a first dielectric housing (12) having multiple terminal receiving channels (14) mating with said second contact ends of said electrical terminals (34) on said first side (30) of said circuit board (11) ;

a second dielectric housing (13) for covering said impedance elements (35) on said second side (31) of said circuit board (11) ; and

means (20) for retaining said first dielectric housing (12), said circuit board (11), and said second dielectric housing (13) in assembled sandwiched relationship ; wherein said impedance elements (35) are selected, and said signal leads (33) are arranged, such that said second ends of said electrical terminals (34) present a desired impedance for terminating said signal path.

2. An electrical termination device (10) according to claim 1, wherein said array of signal terminals (34) of said signal path form an input/output port in electronic equipment.

3. A termination device (10) according to claims 1 or 2, wherein said electrical terminals (34) and said signal terminals are hermaphroditic.

4. A termination device (10) according to claim 3, wherein said electrical terminals (34) and said signal terminals are serpent terminals.

5. A termination device (10) according to any of claims 1 to 4, wherein said impedance elements (35) are resistive elements.

6. A termination device (10) according to claim 5, wherein said resistive elements (35) are resistor networks having a plurality of network terminals.

7. A termination device (10) according to claim 6, wherein each of said resistor networks (35) has twelve of said network terminals and is equivalents to six resistors.

8. A termination device (10) according to claim 6 or 7, comprising four of said resistor networks (35).

9. A termination device (10) according to any of claims 1 to 8, wherein said desired impedance matches said characteristic impedance.

## Ansprüche

1. Elektrische Abschlußvorrichtung (10) für das Ende eines Signalweges, der eine charakteristische Impedanz und eine Anordnung von Signalanschlüssen hat, wobei die elektrische Abschlußvorrichtung (10) aufweist :

eine Schaltkarte (11), die erste und zweite Seiten (30, 31) und eine Mehrzahl von Durchgangsöffnungen (32) sowie Signalleitungen (33) auf wenigstens einer Seite (31) in elektrischem Kontakt mit der Mehrzahl von Durchgangsöffnungen (32) hat,

eine Mehrzahl von elektrischen Anschlüssen (34), wobei jeder elektrische Anschluß (34) erste und zweite Kontaktenden hat, jeder elektrische Anschluß (34) an der ersten Seite (30) der Schaltkarte (11) in einer der zugeordneten Durchgangsöffnungen der Mehrzahl von Durchgangsöffnungen (32) in elektrischem Kontakt mit diesen an dem ersten Kontaktende angebracht ist, und wobei die elektrischen Anschlüsse (34) im wesentlichen senkrecht zu der Schaltkarte (11) und im wesentlichen parallel zueinander in einer zu der Anordnung der Signalanschlüsse komplementären Anordnung verlaufen,

eine Mehrzahl von Impedanzelementen (35), die auf der zweiten Seite (31) der Schaltkarte (11) vorgesehen sind, wobei jedes Impedanzelement (35) in elektrischem Kontakt mit wenigstens zwei der Mehrzahl von Durchgangsöffnungen (32) vorgesehen ist,

ein erstes, dielektrisches Gehäuse (12), das eine Mehrzahl von Anschlußaufnahmekanälen (14) hat, die in Eingriff mit den zweiten Kontaktenden der elektrischen Anschlüsse (34) auf der ersten Seite (30) der Schaltkarte (11) sind,

ein zweites dielektrisches Gehäuse (13) zum Abdecken der Impedanzelemente (35) auf der zweiten Seite (31) der Schaltkarte (11), und

eine Einrichtung (20) zum Festlegen des ersten dielektrischen Gehäuses (12), der Schaltkarte (11) und des zweiten dielektrischen Gehäuses (13) in einer zusammengebauten Zwischenlageanordnung, wobei die Impedanzelemente (35) ausgewählt werden und die Signalleitungen (33) derart eingerichtet sind, daß die zweiten Enden der elektrischen Anschlüsse (34) eine gewünschte Impedanz zum Anschluß des Signalweges hat.

2. Elektrische Abschlußvorrichtung (10) nach Anspruch 1, bei der die Anordnung von Signalanschlüssen (34) des Signalweges eine Eingangs/Ausgangsöffnung in einer elektronischen Einrichtung bildet.

3. Abschlußvorrichtung (10) nach Anspruch 1 oder 2, bei der die elektrischen Anschlüsse (34) und die Signalanschlüsse als Zwitterteile ausgebildet sind.

4. Abschlußvorrichtung (10) nach Anspruch 3, bei der die elektrischen Anschlüsse (34) und die Signalanschlüsse schlangenförmige Anschlüsse sind.

5. Abschlußvorrichtung (10) nach einem der Ansprüche 1 bis 4, bei der die Impedanzelemente (35) Widerstandselemente sind.

6. Abschlußvorrichtung (10) nach Anspruch 5, bei der die Widerstandselemente (35) Widerstandsnetzwerke sind, die eine Mehrzahl von Netzwerkanschlüssen haben.

7. Abschlußvorrichtung (10) nach Anspruch 6, bei der die jeweiligen Widerstandsnetzwerke (35) zwölf der Netzwerkanschlüsse haben und dies äquivalent zu sechs Widerständen ist.

8. Abschlußvorrichtung (10) nach Anspruch 6 oder 7, die vier der Widerstandsnetzwerke (35) aufweist.

9. Abschlußvorrichtung (10) nach einem der Ansprüche 1 bis 8, bei der die gewünschte Impedanz auf die charakteristische Impedanz abgestimmt ist.

## Revendications

1. Un dispositif électrique terminal (10) pour la connexion d'une voie de signal possédant une impédance caractéristique et comprenant un arrangement de bornes de signaux, ledit dispositif électrique terminal (10) comprenant :

– une carte à circuits (11) comprenant des première et seconde faces (30, 31) et une pluralité de trous de passage (32), ainsi que des conducteurs de signaux (33) sur au moins une face (31), en contact électrique avec ladite pluralité de trous de passage (32),

– une pluralité de bornes électriques (34), chacune desdites bornes électriques (34) comprenant des première et seconde extrémités de contacts, chacune desdites bornes électriques (34) étant montée sur ladite première face (30) de ladite carte à circuits (11) dans un trou correspondant de ladite pluralité de trous de passage (32), en contact électrique avec ceux-ci sur ladite première extrémité de contact, lesdites bornes électriques (34) étant orientées sensiblement perpendiculairement par rapport à ladite carte à circuits (11), sensiblement parallèlement les uns par rapport aux autres, dans un arrangement complémentaire dudit arrangement de bornes de signaux,

– une pluralité d'éléments d'impédance (35) montés sur ladite seconde face (31) de ladite carte à circuits (11), chacun desdits éléments d'impédance (35) étant monté en contact électrique avec au moins deux trous de ladite pluralité de trous de passage (32),

– un premier boîtier diélectrique (12) comprenant des canaux de réception terminaux multiples (14) complémentaires desdites secondes extrémités de contacts desdites bornes électriques (34) de ladite première face (30) de ladite carte à circuits (11),

– un second boîtier diélectrique (13) pour recouvrir lesdits éléments d'impédance (35) sur ladite seconde face (31) de ladite carte à circuits (11), et

– des moyens (20) pour retenir ledit premier boîtier diélectrique (12), ladite carte à circuits (11) et ledit second boîtier diélectrique (13) rassemblé dans un montage en sandwich, de manière à pouvoir choisir lesdits éléments d'impédance (35), et à disposer lesdits conducteurs de signaux (33) de telle sorte que lesdites secondes extrémités desdites bornes électriques (34) présentent l'impédance désirée pour fermer ladite voie de signal.

2. Un dispositif électrique terminal (10) selon la revendication 1, dans lequel ledit arrangement de bornes de signaux (34) de ladite voie de signaux forme un port entrée/sortie d'un appareil électronique.

3. Un dispositif terminal (10) selon les revendications 1 ou 2, dans lequel lesdites bornes électriques (34) et lesdites bornes de signaux sont hermaphrodites.

4. Un dispositif terminal (10) selon la revendication 3, dans lequel lesdites bornes électriques (34) et lesdites bornes de signaux sont des bornes en serpentin.

5. Un dispositif terminal (10) selon l'une quelconque des revendications 1 à 4, dans lequel lesdits éléments d'impédance (35) sont des éléments résistifs.

6. Un dispositif terminal (10) selon la revendication 5, dans lequel lesdits éléments résistifs (35) sont des réseaux de résistances comprenant une pluralité de bornes de réseau.

7. Un dispositif terminal (10) selon la revendication 6, dans lequel chacun desdits réseaux de résistances (35) comprend douze desdites bornes de réseau et équivaut à six résistances.

8. Un dispositif terminal (10) selon la revendication 6 ou 7, comprenant quatre desdits réseaux de résistances (35).

9. Un dispositif terminal (10) selon l'une quelconque des revendications 1 à 8, dans lequel ladite impédance voulue est en correspondance avec ladite impédance caractéristique.

FIG.1

FIG.2

FIG.3

FIG.4

FIG.5

FIG.6